Europäisches Patentamt

European Patent Office

Office européen des brevets

(19)

(11) Publication number: **0 531 526 A1**

## EUROPEAN PATENT APPLICATION
### published in accordance with Art. 158(3) EPC

(21) Application number: 91905485.8

(22) Date of filing: **06.03.91**

(86) International application number:
**PCT/JP91/00298**

(87) International publication number:
**WO 92/16020 (17.09.92 92/24)**

(51) Int. Cl.5: **H01L 29/788**

(43) Date of publication of application:
**17.03.93 Bulletin 93/11**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **YAMADA, Seiji, Meitsu Ohimachi 504**
**1-11-5, Futaba**

**Shinagawa-ku**
**Tokyo 142(JP)**
Inventor: **NARUKE, Koyomi, Ohtsu Hights No. 202**
**3-15-10, Haramachida Machida-shi**
**Tokyo 194(JP)**

(74) Representative: **Lehn, Werner, Dipl.-Ing. et al**
**Hoffmann, Eitle & Partner Patentanwälte**
**Arabellastrasse 4**
**W-8000 München 81 (DE)**

(54) NON-VOLATILE SEMICONDUCTOR MEMORY CELL HAVING GATE ELECTRODE ON SIDEWALL OF GATE ELECTRODE PART.

(57) A non-volatile semiconductor memory cell which has a gate electrode part (11) such that a floating gate (5), a second insulating film (6) and a control gate electrode (7) are formed in this order on a first conductive type semiconductor substrate (1). Further, a side part insulating film (8) is formed on the sidewall of the gate electrode part (11), and on the film (8) a sidewall gate electrode (10) insulated from the substrate (1) by a third insulating film (9). In the memory cell having such a constitution, according to this invention, the ratio (C1/C2) of the capacitance C1 between the floating and control electrodes to the capacitance C2 between the floating and sidewall gate electrodes is made to be (C1/C2) > 4, for transferring the potential of the control gate electrode to the floating gate electrode effectively.

F I G. 3

EP 0 531 526 A1

Technical Field

The present invention relates to an E$^2$PROM nonvolatile semiconductor memory cell having a gate electrode on the side wall of a gate electrode section and, more particularly, to an electrostatic capacitance between electrodes of a memory cell.

Background Art

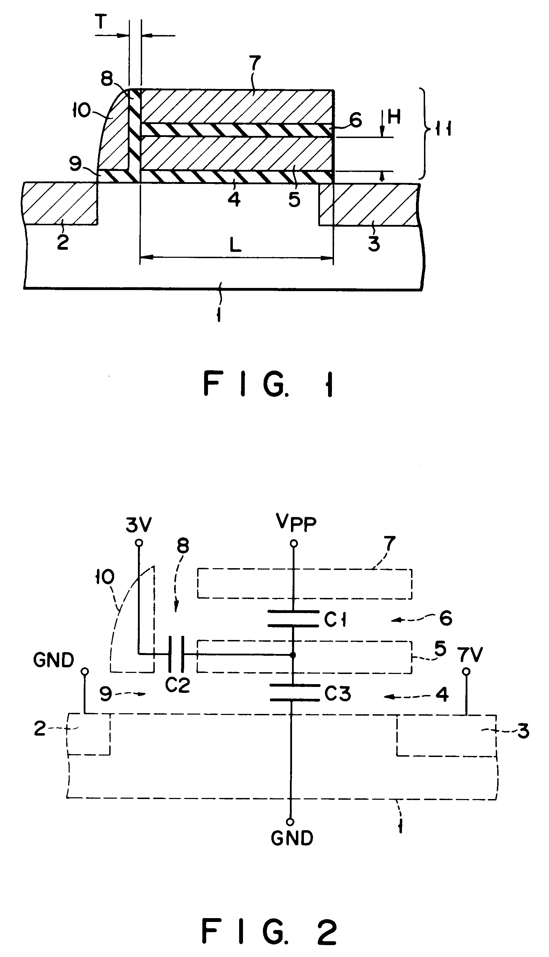

As a conventional nonvolatile semiconductor memory cell, an E$^2$PROM cell having a section shown in Fig. 1 is proposed.

Reference Literature

IEDM89 Digest of Technical Papers. pp. 603 to 606. As shown in Fig. 1, a source region 2 of a second conductivity type and a drain region 3 of the second conductivity type are formed in a semiconductor substrate 1 of a first conductivity type. A first gate insulating film 4 is formed on the substrate 1 between the regions 2 and 3. A floating gate electrode 5 is formed on the fist gate insulating film 4. A second gate insulating film 6 is formed on the floating gate electrode 5. A control gate electrode 7 is formed on the second gate insulating film 6. A side insulating film 8 is formed on the side wall of a gate electrode section constituted by the floating gate electrode 5, the second gate insulating film 6, and the control gate electrode 7. A third gate insulating film 9 combined in the side insulating film 8 is formed on the substrate 1. A select gate electrode 10 is formed on the side insulating film 8 and the third gate insulating film 9.

Fig. 2 is a view showing the electrostatic capacitance of the E$^2$PROM shown in Fig. 1. The same reference numerals as in Fig. 1 denote the same parts in Fig. 2.

As shown in Fig. 2, a first electrostatic capacitance C1 is formed between the floating gate electrode 5 and the control gate electrode 7. A second electrostatic capacitance C2 is formed between the floating gate electrode 5 and the select gate electrode 10. A third electrostatic capacitance C3 is formed between the floating gate electrode 5 and the substrate 1.

Data is to be written in the E$^2$PROM having these capacitances, i.e., electrons are injected in the floating gate electrode 5, as described below.

A voltage of 17 V (Vpp potential; program voltage) is applied to the control gate electrode 7, a voltage of 3 V or 1.5 V is applied to the select gate electrode 10, and a voltage of 7 V or 5 V is applied to the drain region 3. When these voltages are applied to the memory cell, hot electrons are generated by a channel region. The hot electrons are mainly injected in the floating gate electrode 5 through the first gate insulating film 4.

At this time, the first electrostatic capacitance C1 is actioned to increase the potential of the floating gate electrode 5. That is, the first capacitance C1 is actioned to increase the potential of the floating gate electrode 5 to 17 V.

However, the second electrostatic capacitance C2 and third electrostatic capacitance C3 are actioned to decrease the potential of the floating gate electrode 5. That is, the second capacitance C2 is actioned to decrease the potential of the floating gate electrode 5 to 3 V, and the third capacitance C3 is actioned to decrease the potential of the floating gate electrode 5 to 0 V (GND).

In the E$^2$PROM having the above constitution when data is to be written, the three electrostatic capacitances act around the floating gate electrode 5. Of the three electrostatic capacitances although the first electrostatic capacitance C1 is actioned to increase the potential of the floating gate electrode 5, the second and third capacitances C2 and C3 are actioned to decrease the potential of floating gate electrode 5. For this reason, in this cell, a potential applied to the control gate cannot be efficiently transmitted to the floating gate electrode.

It is, therefore, an object of the present invention to provide a nonvolatile semiconductor memory cell, having a gate electrode on the side wall of a gate electrode section, capable of efficiently transmitting a potential applied to a control gate electrode to a floating gate electrode.

Disclosure of Invention

A nonvolatile semiconductor memory cell of the present invention comprises a semiconductor substrate of a first conductivity type having a major surface, a first insulating film formed on the major surface of the substrate, a floating gate electrode formed on the first insulating film, a second insulating film formed on the floating gate, a control gate formed, a gate electrode section constituted by the floating gate electrode, the second gate insulating film, and the control gate electrode, and a side insulating film formed on at least one side wall of the gate electrode section, a third gate insulating film formed on the major surface of the substrate and brought into contact with the side insulating film, a side-wall gate electrode formed on the third gate insulating film and the side insulating film, and a semiconductor region formed on the major surface of the substrate which is not covered with the gate electrode unit, the side insulating film, and the side-wall gate electrode. A ratio (C1/C2) of a first capacitance C1 formed between the floating gate electrode and the control gate electrode to a second capacitance C2 formed between the floating gate electrode and the side-wall gate electrode is given by

(C1/C2) > 4.

Brief Description of Drawings

Fig. 1 is a sectional view showing a conventionally proposed memory cell;
Fig. 2 is a view showing the electrostatic capacitance of the memory cell shown in Fig. 1;
Fig. 3 is a sectional view showing a memory cell according to the first embodiment of the present invention;
Fig. 4 is a graph showing a relationship between a height H of a floating gate and a program voltage Vpp;
Fig. 5 is a sectional view showing a memory cell according to the second embodiment of the present invention;
Fig. 6 is a graph showing a relationship between a film thickness T of a side insulating film and a program voltage Vpp; and
Fig. 7 is a sectional view showing a memory cell according to the third embodiment of the present invention.

Best Mode of Carrying Out the Invention

[First Embodiment]

The original dimensions of an E$^2$PROM cell shown in Fig. 1 will be described below.
Length L in channel length direction: about 1.2 $\mu$m
Length W (not shown) in channel width direction: about 2.0 $\mu$m
Height H: about 0.4 $\mu$m
Thickness T of side insulating film 8: about 0.04 $\mu$m of silicon oxide film
Thickness of second gate insulating film 6: 0.03 $\mu$m
A first electrostatic capacitance C1 is calculated on the basis of the above dimensions as follows:

$$C = \epsilon_0 \cdot \epsilon r \cdot (S/d) \qquad (1)$$

$\epsilon_0$:     electric constant
$\epsilon r$:     relative dielectric constant
S:     area of electrode
d:     distance (thickness of dielectric)

When the values of the dimensions are substituted in Equation (1), the first electrostatic capacitance C1 is given by:

$$C1 = \epsilon_0 \cdot \epsilon r \cdot \left\{ (1.2 \times 2.0)/0.03 \right\}$$
$$= 80 \times 10^{-6} \cdot \epsilon_0 \cdot \epsilon r \ [m \cdot F/m]$$

Similarly, a second electrostatic capacitance C2 is given by:

$$C2 = \varepsilon_0 \cdot \varepsilon r \cdot \{(0.4 \times 2.0)/0.04\}$$
$$= 20 \times 10^{-6} \cdot \varepsilon_0 \cdot \varepsilon r \ [m \cdot F/m]$$

In addition, a ratio (C1/C2) of the first capacitance C1 to the second electrostatic capacitance C2 is given by:

$$(C1/C2) = 80 \times 10^{-6} \cdot \varepsilon_0 \cdot \varepsilon r/20 \times 20^{-6} \cdot \varepsilon_0 \cdot \varepsilon r$$
$$= 4$$

A ratio (L/H) of the length L in the channel length direction of a floating gate electrode 5 to the height H of the floating gate electrode 5 is given by:

$$(L/H) = 1.2/0.4$$
$$= 3$$

A ratio (L/T) of the length L in the channel length direction of a floating gate electrode 5 to the film thickness T of a side insulating film 8 is given by:

$$(L/T) = 1.2/0.04$$
$$= 30$$

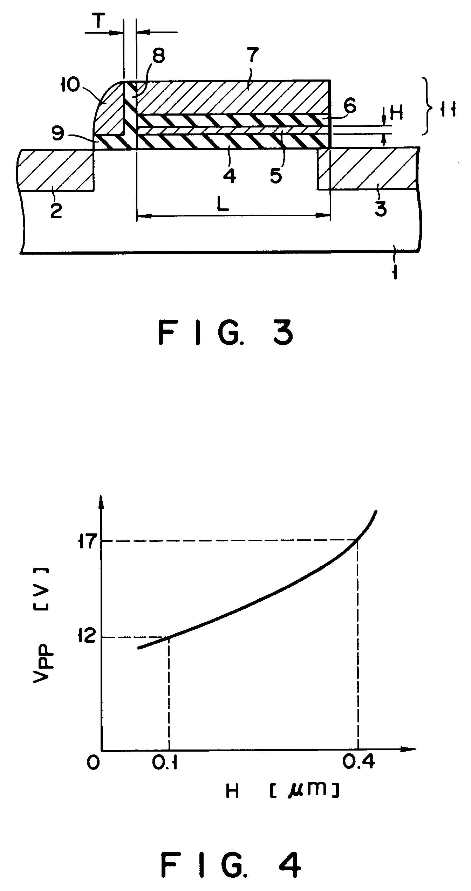

Fig. 3 is a sectional view of a memory cell according to the first embodiment of the present invention. The same reference numerals as in Fig. 1 denote the same parts in Fig. 3.

As shown in Fig. 3, a source region 2 of a second conductivity type and a drain region 3 of the second conductivity type are formed in a semiconductor substrate 1 of a first conductivity type. A first gate insulating film 4 is formed on the semiconductor substrate 1 between the regions 2 and 3. A floating gate electrode 5 is formed on the first gate insulating film 4. The floating gate electrode 5 consists of, e.g., polysilicon. As the dimensions of the floating gate electrode 5, for example, a length L in a channel length direction is about 1.2 $\mu$m, a length W (not shown) in a channel width direction is about 2.0 $\mu$m, and a height H is about 0.1 $\mu$m. A second gate insulating film 6 is formed on the floating gate electrode 5. The second gate insulating film 6 comprises, e.g., a silicon oxide film. The second gate insulating film 6 has a film thickness T of about 0.03 $\mu$m. A control gate electrode 7 is formed on the second gate insulating film 6. A side insulating film 8 is formed on the side wall of a gate electrode section 11 constituted by the floating gate electrode 5, the second gate insulating film 6, and the control gate electrode 7. The side insulating film 8 is formed by, e.g., a silicon oxide film. The side insulating film 8 has a film thickness T of about 0.04 $\mu$m. A third gate insulating film 9 integrated with the side insulating film 8 is formed on the substrate 1. The third gate insulating film 9 and the side insulating film 8 are formed as follows.

First, the first gate insulating film 4, the floating gate electrode 5, the second gate insulating film 6, and the control gate electrode 7 are simultaneously patterned to obtain the gate electrode section 11. In this specification, the gate electrode section 11 is defined by the floating gate electrode 5, the second gate insulating film 6, and the control gate electrode 7 for descriptive convenience. The surfaces of the gate electrode section 11 and the substrate 1 are oxidized to obtain the third gate insulating film 9 and the side insulating film 8. A select gate electrode 10 is formed on the side insulating film 8 and the third gate insulating film 9 which are formed as described above.

In the cell having the above arrangement according to the first embodiment, especially, the height H of the floating gate electrode 5 is set to be smaller than the original height. For this reason, an opposite area between the floating gate electrode 5 and the select gate electrode 10 is decreased, thereby decreasing the electrostatic capacitance C2.

Fig. 4 is a graph showing a relationship between the height H of the floating gate electrode 5 and a potential (program potential Vpp) of the control gate electrode 7.

As shown in Fig. 4, when the floating gate electrode 5 has the original dimension (H = 0.4 $\mu$m), a voltage of 17 V is required as the program potential Vpp used for write access of data.

In the cell according to the first embodiment, however, since the height H of the floating gate electrode 5 is set to be 0.1 $\mu$m, the program potential Vpp can be decreased to 12 V.

At this time, the first and second electrostatic capacitances C1 and C2 of the cell according to the first embodiment of the present invention are calculated to be described below.

First, the first electrostatic capacitance C1 is given by:

$$C1 = \varepsilon_0 \cdot \varepsilon r \cdot \{(1.2 \times 2.0)/0.03\}$$
$$= 80 \times 10^{-6} \cdot \varepsilon_0 \cdot \varepsilon r \ [m \cdot F/m]$$

Similarly, the second electrostatic capacitance C2 is given by:

$$C2 = \varepsilon_0 \cdot \varepsilon r \cdot \{(0.1 \times 2.0)/0.04\}$$
$$= 5 \times 10^{-6} \cdot \varepsilon_0 \cdot \varepsilon r \ [m \cdot F/m]$$

In addition, a ratio (C1/C2) of the first electrostatic capacitance C1 to the second electrostatic capacitance C2 is given by:

$$(C1/C2) = 80 \times 10^{-6} \cdot \varepsilon_0 \cdot \varepsilon r/5 \times 20^{-6} \cdot \varepsilon_0 \cdot \varepsilon r$$
$$= 16$$

A ratio (L/H) of the length L in the channel length direction of the floating gate electrode 5 to the height H of the floating gate electrode 5 is given by:

$$(L/H) = 1.2/0.1$$
$$= 12$$

As described above, when the height H of the floating gate electrode 5 is decreased, the electrostatic capacitance C2 between the floating gate electrode 5 and the select gate electrode 10 can be decreased. As a result, when electrons are injected in the floating gate electrode 5, even when a voltage applied to the control gate electrode 7 is low, the potential of the floating gate electrode 5 can be easily increased. Therefore, in the E[2]PROM cell according to the present invention, a voltage (program voltage Vpp) for injecting electrons in the floating gate electrode 5 can be decreased.

[Second Embodiment]

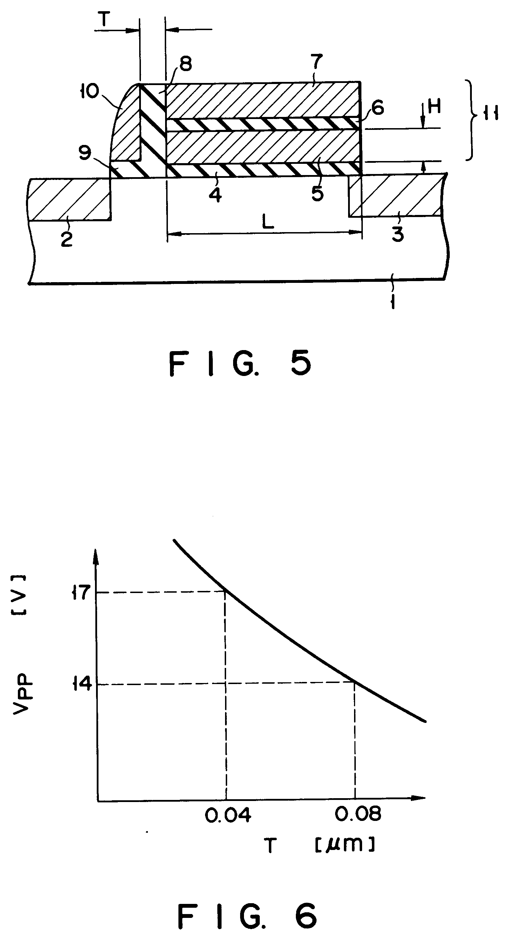

Fig. 5 is a sectional view showing a memory cell according to the second embodiment of the present invention. The same reference numerals as in Fig. 3 denote the same parts in Fig. 5, and a description thereof will be omitted.

Difference points between the memory cell shown in Fig. 5 and the memory cell shown in Fig. 3 are as follows.

That is, the dimension, especially a height H, of a floating gate electrode 5 is set to be about 0.4 $\mu$m, and a film thickness T of a side insulating film (silicon oxide film) 8 is set to be about 0.08 $\mu$m.

In the memory cell having the above arrangement according to the second embodiment, especially, the film thickness T of the side insulating film 8 is set to be larger than the original film thickness. For this reason, the film thickness of a dielectric between the floating gate electrode 5 and a select gate electrode 10 is increased, and an electrostatic capacitance C2 is decreased.

Fig. 6 is a graph showing a relationship between the film thickness T of the side insulating film 8 and the potential (program potential Vpp) of a control gate electrode 7.

As shown in Fig. 6, when the side insulating film 8 has the original dimension (T = 0.04 $\mu$m), a voltage of 17 V is required as the program potential Vpp used for write access of data.

In the memory cell according to the second embodiment, however, when the film thickness T of the side insulating film 8 is set to be 0.08 $\mu$m, the program potential Vpp can be decreased to 14 V.

At this time, first and second electrostatic capacitances C1 and C2 of the cell according to the first embodiment of the present invention are calculated as follows.

First, the first electrostatic capacitance C1 is given by:

$$C1 = \varepsilon_0 \cdot \varepsilon r \cdot \{(1.2 \times 2.0)/0.03\}$$
$$= 80 \times 10^{-6} \cdot \varepsilon_0 \cdot \varepsilon r \ [m \cdot F/m]$$

Similarly, the second electrostatic capacitance C2 is given by:

$$C2 = \varepsilon_0 \cdot \varepsilon r \cdot \{(0.4 \times 2.0)/0.08\}$$
$$= 10 \times 10^{-6} \cdot \varepsilon_0 \cdot \varepsilon r \ [m \cdot F/m]$$

In addition, a ratio (C1/C2) of the first electrostatic capacitance C1 to the second electrostatic capacitance C2 is given by:

$$(C1/C2) = 80 \times 10^{-6} \cdot \varepsilon 0 \cdot \varepsilon r/10 \times 20^{-6} \cdot \varepsilon 0 \ y \ \varepsilon r$$
$$= 8$$

A ratio (L/T) of the length L in the channel length direction of the floating gate electrode 5 to the film thickness T of the side insulating film 8 is given by:

$$(L/T) = 1.2/0.08$$
$$= 15$$

As described above, when the film thickness T of the side insulating film 8 is increased, the electrostatic capacitance C2 between the floating gate electrode 5 and the select gate electrode 10 can be decreased. The voltage (program voltage) for injecting electrons in the floating gate electrode 5 can be decreased.

[Third Embodiment]

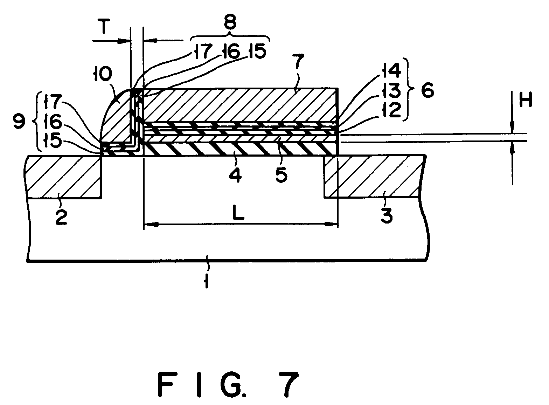

Fig. 7 is a sectional view of a memory cell according to the third embodiment of the present invention. The same reference numerals as in Fig. 3 denote the same parts in Fig. 7, and a description thereof will be omitted.

Difference points between the memory cell shown in Fig. 7 and the memory cell shown in Fig. 3 are as follows.

That is, a multi-layered insulating film constituted by a second gate insulating film 6, a silicon oxide film 12, a silicon nitride film 13, and a silicon oxide film 14 is used, and each of the side insulating film 8 and a third gate insulating film 9 is a multi-layered insulating film constituted by a silicon oxide film 15, a silicon nitride film 16, and a silicon oxide film 17.

In the memory cell having the above arrangement, when a height H of the floating gate electrode 5 is decreased as in the first embodiment, an electrostatic capacitance C2 between the floating gate electrode 5 and a select gate electrode 10 can be decreased.

As described above, according to the present invention described with reference to the first to third embodiments, when the height H of the floating gate electrode 5 is decreased, or the thickness T of the side insulating film 8 is increased, the electrostatic capacitance C2 formed between the floating gate electrode 5 and the select gate electrode 10 can be decreased. When the electrostatic capacitance C2 becomes small, the memory cell is not easily affected by the potential of the select gate electrode 10. For this reason, a voltage applied to the control gate electrode 7 can be efficiently transmitted to the floating gate electrode 5. As a result, during write access of data, a voltage applied to the control gate electrode can be decreased, thereby obtaining a low program voltage Vpp.

For example, in the first embodiment, the program voltage Vpp can be set to be 12 V. This voltage of 12 V is almost equal to the program voltage Vpp (Vpp = 12. 5) of a popularly used EPROM. This has an advantage in that a power supply of a conventional EPROM can be directly used in the memory cell of the present invention.

In the memory cells described in the first to third embodiments, the select gate electrode 10 is formed on only the source region 2 side of the gate electrode section 11. However, the present invention is not limited to the above embodiments, and a side-wall gate electrode may be formed on both the sides of the gate electrode section. In this case, as described in the first and second embodiments, when the height H of the floating gate electrode is decreased, or the film thickness T of the side insulating film is increased, a capacitance formed between the floating gate electrode and the side-wall gate electrode can be decreased.

In addition, various modifications can be effected without departing from the spirit and scope of the present invention. Industrial Applicability

As described above, in a memory cell according to the present invention, a potential applied to a control gate electrode can be efficiently transmitted to a floating gate electrode. For this reason, a program voltage used for, e.g., write access of data, can be set to be low. Therefore, the present invention can be effectively applied to an $E^2$PROM having a select gate electrode formed on the side wall of a gate electrode section.

## Claims

1. A nonvolatile semiconductor memory cell comprising:

   a semiconductor substrate of a first conductivity type having a major surface;

   a first insulating film formed on the major surface of said substrate;

   a floating gate electrode formed on said first insulating film, a control gate formed;

   a gate electrode section constituted by said floating gate electrode, said second gate insulating film, and the control gate electrode, and a side insulating film formed on at least one side wall of said gate electrode section;

   a third gate insulating film formed on the major surface of said substrate and brought into contact with said side insulating film;

   a side-wall gate electrode formed on said third gate insulating film and said side insulating film; and

   a semiconductor region formed on the major surface of said substrate which is not covered with said gate electrode unit, said side insulating film, and said side-wall gate electrode,

   wherein a ratio (C1/C2) of a first electrostatic capacitance C1 formed between said floating gate electrode and said control gate electrode to a second electrostatic capacitance C2 formed between said floating gate electrode and said side-wall gate electrode is given by

   (C1/C2) > 4.

2. A nonvolatile semiconductor memory cell according to claim 1, wherein a ratio (L/H) of a length L of said floating gate electrode in a channel length direction to a height H of said floating gate electrode is given by

   (L/H) > 3.

3. A nonvolatile semiconductor memory cell according to claim 1, wherein a ratio (L/T) of a length L of said floating gate electrode in a channel length direction to a film thickness T of said third insulating film is given by

   (L/T) < 30.

4. A nonvolatile semiconductor memory cell according to claim 1, wherein said side insulating film is a silicon oxide film.

5. A nonvolatile semiconductor memory cell according to claim 2, wherein said side insulating film is a silicon oxide film.

6. A nonvolatile semiconductor memory cell according to claim 3, wherein said side insulating film is a silicon oxide film.

7. A nonvolatile semiconductor memory cell according to claim 1, wherein said side insulating film is a multi-layered insulating film constituted by a silicon oxide film and a silicon nitride film.

8. A nonvolatile semiconductor memory cell according to claim 2, wherein said side insulating film is a multi-layered insulating film constituted by a silicon oxide film and a silicon nitride film.

F I G. 1

F I G. 2

F I G. 3

F I G. 4

F I G. 5

F I G. 6

# F I G. 7

# INTERNATIONAL SEARCH REPORT

International Application No PCT/JP91/00298

| **I. CLASSIFICATION OF SUBJECT MATTER** (if several classification symbols apply, indicate all) 6 |
|---|

According to International Patent Classification (IPC) or to both National Classification and IPC

Int. Cl$^5$  H01L29/788

| **II. FIELDS SEARCHED** |
|---|

| Minimum Documentation Searched 7 | |
|---|---|
| Classification System | Classification Symbols |
| IPC | H01L29/788 |

Documentation Searched other than Minimum Documentation
to the Extent that such Documents are Included in the Fields Searched 8

| | |
|---|---|
| Jitsuyo Shinan Koho | 1971 - 1990 |
| Kokai Jitsuyo Shinan Koho | 1971 - 1990 |

### III. DOCUMENTS CONSIDERED TO BE RELEVANT 9

| Category * | Citation of Document, 11 with indication, where appropriate, of the relevant passages 12 | Relevant to Claim No. 13 |
|---|---|---|
| X | JP, A, 2-114674 (Seiko Instruments Inc.), April 26, 1990 (26. 04. 90), | 1-8 |
| X | JP, A, 3-3274 (Seiko Instruments Inc.), January 9, 1991 (09. 01. 91) | 1-8 |

* Special categories of cited documents: 10

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

### IV. CERTIFICATION

| Date of the Actual Completion of the International Search | Date of Mailing of this International Search Report |
|---|---|
| May 21, 1991 (21. 05. 91) | June 3, 1991 (03. 06. 91) |

| International Searching Authority | Signature of Authorized Officer |
|---|---|
| Japanese Patent Office | |

Form PCT/ISA/210 (second sheet) (January 1985)

See notes on accompanying sheet